# EUROPEAN PATENT APPLICATION

(11) **EP 3 203 257 A1**
(43) Date of publication of application: **09.08.2017**
(21) Application number: 15846404.0
(22) Date of filing: 02.10.2015
(51) Int. Cl.: G01R 35/00

(54) **DEVICE FOR CALIBRATING NETWORK ANALYSERS**

(30) Priority: 03.10.2014 ES 201431464
(71) Applicant: Universitat Politécnica de Valencia, 46022 Valencia (ES); Universidad de Castilla La Mancha, 02071 Albacete (ES)
(72) Inventor: BELENGUER MARTÍNEZ, Angel, E-02071 Albacete (ES); DIAZ CABALLERO, Elena, E-46022 Valencia (ES); ESTEBAN GONZALEZ, Hector, E-46022 Valencia (ES); BORIA ESBERT, Vicente Enrique, E-46022 Valencia (ES)
(74) Representative: Pons Ariño, Angel
(86) International application number: PCT/ES2015/070721
(87) International publication number: WO 2016/051008

(57) **Abstract**

The invention relates to a device for calibrating vector network analysers, implemented by means of SIC, ESIW and microstrip technologies. The calibration device of the invention is characterised in that it is a modular device comprising connection modules (5) connected to the vector analyser and to calibration modules (which can be SIC, ESIW or microstrip modules). This modular configuration allows the noises that are intrinsic to the connection to the analyser (including transfers to microstrip, SIC, etc.) to be the same in all of the calibration measurements, allowing the noises associated with each connection to be detected and/or eliminated.

## Description

### OBJECT OF THE INVENTION

The present invention relates to a network analyzer calibration device. In particular, it relates to a network analyzer calibration device implemented by means of SIC (Substrate Integrated Circuit) technology.

### BACKGROUND OF THE INVENTION

Various network analyzers are known in the prior art. Said network analyzers are analysis instruments of the properties of electrical networks, especially those properties associated with the reflection and transmission of electric signal, known as dispersion parameters (Parameters-S). Network analyzers operate between the ranges of 9 kHz and 110 GHz.

Said network analyzers require a correction of the systematic errors that occur due to the presence of cables, terminals, among others, in the analyzer. To do this, it is necessary to calibrate the apparatus before taking any measurements. The calibration of a network analyzer is a high-precision process wherein it is necessary to consider both the impedance wherein it is operating and the conditions wherein the equipment is operating. The calibration standard is based on four test devices called THRU (connected network), LINE (empty line segment) REFLECT (network in short-circuit) to calibrate the transmission, which must be connected to the analyzer ports so that it can compare and establish the difference between these different modes and their ideal responses. These data are saved in a log and each log may be independently calibrated and at the time when a modification is made to the network under study.

Typically, the manufacturers of said network analyzers supply kits for equipment calibration. Said kits are usually devices, mainly mechanical, in particular, rectangular waveguides. These rectangular waveguides are high-cost devices due to the precision of their dimensions and there are usually four devices, in particular, one device for each one of the measurements: THRU, LINE and REFLECT.

Furthermore, in the article by E. Diaz, A. Belenguer, H. Esteban and V. Boria, "Thru-reflect-line calibration for substrate integrated waveguide with tapered microstrip transitions, published in Electronic Letters, Vol. 49(2), pp 132-133 (2013) it discloses a calibration kit based on SIC technology, in particular, using SIW (Substrate Integrated Waveguide) technology. In this device, it discloses a calibration kit wherein it modifies the traditional waveguide for a substrate integrated waveguide which, despite the losses associated to the use of a dielectric contained in the substrate as means of passage of the waves instead of the air of conventional waveguides, their low cost and their acceptable quality factor make the device highly advantageous with respect to other devices of the prior art.

### DESCRIPTION OF THE INVENTION

The devices of the prior art have the drawback that, as they are independent, each one of the calibration devices (e.g. OPEN, THRU and LINE) have different related electrical behaviour, for example, to the position of their connectors, to the impedance due to the length of the printed circuit paths, to the type of welding, to possible impurities in the welding, in the manner that it is performed, etc.

In consequence, the present invention discloses a device which, by means of the concept of modularity, uses common parts of the device to make these measurements. In consequence, there are measurements, wherein the electrical behaviour is approximately identical and, although the behaviour is not exactly that of the ideal conditions, it is at least the same for all the measurements and the calibration process is performed with similar behaviour for all of them.

In particular, the present invention discloses a network analyzer calibration device comprising:
- a first terminal designed to be connected to a network analyzer;
- a first calibration element disposed in a first calibration module; and
- a second calibration element disposed in a second calibration module;
wherein said first and second calibration elements are substrate integrated elements (i.e. SIW) and wherein the first terminal is disposed in a first connection module, said first connection module having connection means to other modules and wherein the first calibration module and the second calibration module comprise conjugated connection means to the connection means of the first connection module.

Preferably, the first terminal is a terminal for coaxial cable of the type known in the state of the art as "SMA" and wherein the first connection module comprises SMA-to-SIC (Substrate Integrated Circuit) transition means. In particular embodiments of the present invention, the SMA-to-SIC transition means comprises intermediate transition means to pass from SMA to microstrip and from microstrip to SIC, in particular, the transition means comprises SMA-to-microstrip transition means and microstrip-to-SIC transition means.

As regards the calibration elements, the present invention considers, on the one hand, that the calibration elements that require a single terminal may be, for example, OPEN and/or REFLECT elements so that the first calibration element would be an OPEN element and/or a REFLECT element, respectively.

Furthermore, the present invention contemplates that the calibration device of the present invention may take measurements that require two terminals so that the device comprises a second terminal designed to connect to the network analyzer. Preferably, said second terminal is disposed in a second connection module comprising connection means to other modules and, furthermore, said second calibration element may comprise conjugated connection means both to the first and the second connection module.

Similarly to the case of the first terminal, the second terminal is a SMA terminal and wherein the second connection module comprises SMA-to-SIC transition means which may comprise an intermediate passage to microstrip, so that the SMA-to-SIC transition means comprises SMA-to-microstrip transition means and transition means of microstrip to SIC.

Some of the measurements of two terminals considered the present invention are, for example, THRU and/or LINE measurements so that the second calibration element may be a THRU element and/or LINE, respectively. Alternatively, the device of the present invention may comprise two second calibration modules one of said second calibration modules comprising a THRU element and the other of said second calibration means comprising a LINE element.

In an especially preferred embodiment, the network analyzer calibration device of the present invention may be implemented in ESIW (Extended Substrate Integrated Waveguide) technology, which is an embodiment similar to SIW technology which, instead of the waves passing through the dielectric of the substrate, said waves pass through the air, which improves the quality of the signals. In this case, the device comprises:
- a first terminal designed to be connected to a network analyzer;
- a first calibration element disposed in a first calibration module; and
- a second calibration element disposed in a second calibration module;
wherein said first and second calibration elements are empty substrate integrated guides and wherein the first terminal is disposed in a first connection module with said first connection module having connection means to other modules and wherein the first calibration module and the second calibration module comprise conjugated connection means to the connection means of the first connection module.

Preferably, the first terminal is a SMA terminal and wherein the first connection module comprises SMA-to-ESIW transition means. Similarly to the case of the SIW device, said SMA-to-ESIW transition means may comprise SMA-to-microstrip transition means and microstrip-to-ESIW transition means.

In the case of calibration measurements with a single terminal, the device of the present invention may make measurements, for example OPEN and/or REFLECT, so that the first calibration element is an OPEN and/or REFLECT element, with said elements being implemented in ESIW technology.

In the case of calibration measurements that require two terminals, the device of the present invention comprises a second terminal designed to be connected to a network analyzer with said terminal being disposed, preferably, in a second connection module comprising connection means to other modules. Preferably, the second calibration element comprises conjugated connection means both to the first and the second connection module. Additionally, the second terminal may be, for example, a SMA terminal and the second connection module may comprises SMA-to-ESIW transition means. Said transition of SMA to ESIW may comprise SMA-to-microstrip transition means and microstrip-to-ESIW transition means.

As regards the measurements that may be performed using two terminals, the present invention contemplates that, by way of example, it is possible to make THRU and/or LINE measurements so that the second calibration element would be a THRU and/or LINE element, respectively.

Finally, in a preferred embodiment, the device comprises two second calibration modules, one of said second calibration modules comprising a THRU element and the other of said second calibration means comprising a LINE element.

In another especially preferred embodiment, the network analyzer calibration device of the present invention may be implemented in microstrip technology. In this case, the device comprises:
- a first terminal designed to be connected to a network analyzer;
- a first calibration element disposed in a first calibration module; and
- a second calibration element disposed in a second calibration module;
wherein said first and second calibration elements are microstrip lines in substrate and wherein the first terminal is disposed in a first connection module, with said first connection module having connection means to other modules and wherein the first calibration module and the second calibration module comprise conjugated connection means to the connection means of the first connection module.

Preferably, the first terminal is a SMA terminal and wherein the first connection module comprises SMA-to-microstrip transition means.

In the case of calibration measurements with a single terminal, the device of the present invention may perform measurements, e.g. OPEN and/or REFLECT so that the first calibration element is an OPEN and/or REFLECT element with said elements being implemented in microstrip technology.

In the case of calibration measurements that require two terminals, the device of the present invention comprises a second terminal designed to be connected to a network analyzer with said terminal being disposed, preferably, in a second connection module comprising connection means to other modules. Preferably, the second calibration element comprises conjugated connection means both to the first and the second connection module. Additionally, the second terminal may be, for example, a SMA terminal and the second connection module may comprise SMA-to-microstrip transition means.

As regards the measurements that may be made using two terminals, the present invention contemplates that, by way of example, THRU and/or LINE elements may be made so that the second calibration element would be a THRU and/or LINE element respectively.

Finally, in a preferred embodiment, the device comprises two second calibration modules one of said second calibration modules comprising a THRU element and the other of said second calibration means comprising a LINE element.

### DESCRIPTION OF THE DRAWINGS

To complement the description being made and in order to aid towards a better understanding of the characteristics of the invention, in accordance with a preferred example of practical embodiment thereof, a set of drawings is attached as an integral part of said description wherein, with illustrative and non-limiting character, the following has been represented:
Figure 1 shows three calibration devices of the type known in the prior art.
Figure 2 shows an example of transition means of a signal received by means of a SMA-to-SIC connector.
Figure 3 shows an example of connection modules according to the present invention.
Figure 4 shows a mechanical exploded view of a connection module according to the present invention.
Figure 5 shows three examples of calibration modules for a device according to the present invention.
Figure 6 shows an exploded view of the calibration device of the present invention connected for the measurement of a THRU calibration signal.
Figure 7 shows the calibration device of the present invention connected for the measurement of a THRU calibration signal.
Figure 8 shows the calibration device of the present invention connected for the measurement of a LINE calibration signal.
Figure 9 shows the calibration device of the present invention connected for the measurement of a REFLECT calibration signal.
Figure 10 shows the calibration device of the present invention connected for the measurement of a DUT (Device Under Test) device.
Figure 11 shows an example of transition means of a signal received by means of a SMA-to-ESIW connector.
Figure 12 shows the calibration device of the present invention connected for the measurement of a DUT (Device Under Test) device, with the calibration device being a device implemented in ESIW.

### PREFERRED EMBODIMENT OF THE INVENTION

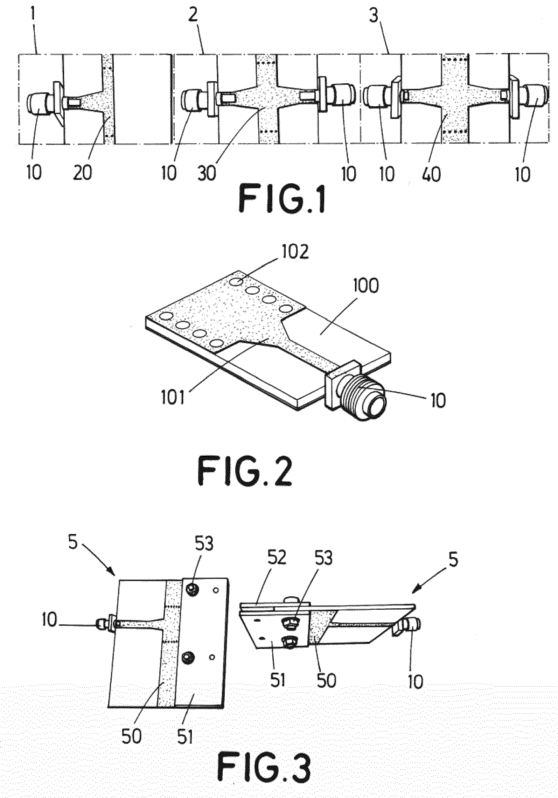

Figure 1 shows three calibration devices of the type known in the prior art. In particular, the devices of the prior art are three independent devices: an OPEN device (1), which is basically an open circuit; a THRU device (2), which is a device which allows the passage of the signal; and a LINE device, which is a device which allows the passage of signal but, unlike the THRU, the signal passage segment has a significant electrical length with respect to the THRU.

As regards the embodiment of the state of the art, it can be highlighted that each one of the elements is implemented in SIC technology which has a dielectric path (20, 30, 40) of a substrate plate so that the signals pass through this dielectric.

One of the main problems that this type of embodiments with various independent devices have is that, for example, the SMA connectors (10) are welded to the substrate and said welding may have impurities, it may be located in a different place in each one of the devices, etc. so that said situations modify the signal measured and add an inadequate noise which, furthermore, it is impossible to anticipate since it is different for each one of the devices.

In the device of the present invention, it intends to use a same SMA connector (10) and its associated elements (such as, for example, SMA-to-microstrip and microstrip-to-SIC transitions) to have a similar noise signal in each one of the measurements, in this way it is easier to locate it and eliminate it from the calibration measurements.

Figure 2 shows an example of transition means of a signal received by means of a SMA-to-SIC connector (10). As previously mentioned, it is the main focus of noises due to the presence of multiple elements the repeatability of which is practically impossible, i.e. each embodiment is unique and induces different noises.

The present invention contemplates a first transition of the signal from a SMA-to-microstrip conductor and then the microstrip signal converts it into a SIC signal. The SMA (10)-to- microstrip transition is performed by means of the welding of the SMA connector (10) to a microstrip path and the microstrip-to-SIC transition is performed by means of processes known in the state of the art, in particular, it is performed by means of the incorporation of a transition (101). Furthermore, the SIC devices have a series of holes (102), which are subjected to a metallization process.

This type of transitions are widely known in the state of the art and are described in detail, for example, in the article: "The substrate integrated circuits - a new concept for high-frequency electronics and optoelectronics" by Ke Wu et al. published in Telecommunications in Modern Satellite, Cable and Broadcasting Service, 2003. TELSIKS 2003. 6th International Conference on (Volume: 1, P - III-P-X), ISBN: 0-7803-7963-2.

Figure 3 shows an example of connection modules (5) according to the present invention. In some of the measurements contemplated in the present invention, there may be a single connection module (5). However, other measurements require two connection modules (5).

In particular, the measurements that require a single connection to the analyzer to calibrate (such as OPEN and REFLECT) are made using a single connection module (5). Indeed, it uses the same connection module and only exchanges the elements corresponding to each measurement. In this way, the noise inherent to the electrical connections and transmissions is the same for the two devices and it may more easily detect and discriminate the measurements.

In particular, the connection module (5) of figure 3 comprises a SMA connector (10) for its connection to the analyzer, the aforementioned SMA-to-SIC transition elements and connection means to other modules.

During the development of the present invention, it has been determined that so that there is a connection between two SIC modules, it is sufficient to perform a joint between them so that the connection means, in particular embodiments, are mechanical joining means of any of the types known in the state of the art.

Figure 3 shows an example of the type of joining means that could be used such as an upper strip (51) and a lower strip (52) joined to the substrate (50) by means of screws (53) with said strips having holes designed to receive other screws that are joined both to the substrate (50) of the connection module (5) and the calibration modules. To do this, the calibration modules must have conjugated connection means to those of the connection module which, in this case, would be conjugated holes that coincide with the holes of the connection module.

These connection means must make the substrate (50) of the connection module adjacent to the substrates of the other modules, performing a physical join between them which allows the passage of signals from one substrate to another.

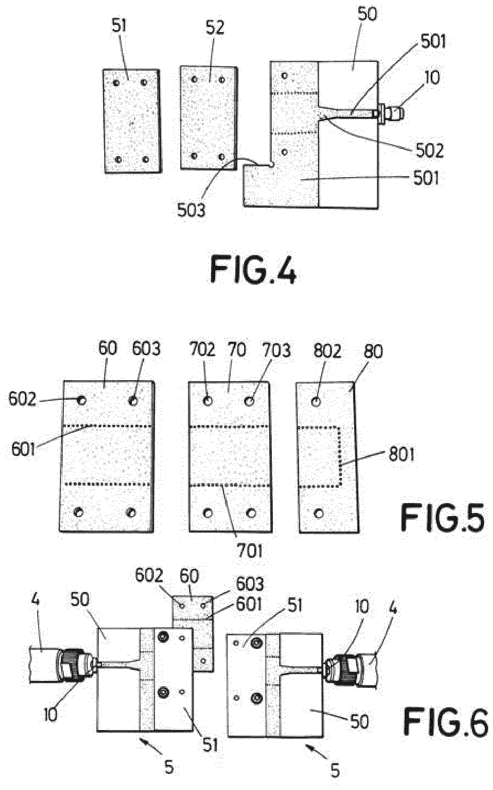

Making reference to figure 4, it is possible to observe the main components of a sample embodiment of a connection module (5). This embodiment of connection module (5) has a substrate (50). Said substrate comprises a transition of SMA (10)-to-microstrip (501) connector and a microstrip (501)-to-SIC transition (502). Furthermore, it has two strips: an upper strip (51) and a lower strip (52) which will be the joining means between modules (together with the holes of the different modules). In this embodiment, of particular relevance is the presence of alignment means (503) between modules which, in this case are disposed as a square, which allows the alignment of the connection modules when they come into contact with at least one side thereof.

Figure 5 shows three examples of calibration modules for a device according to the present invention. In particular, figure 5 shows a THRU module (60), a LINE module (70) and a REFLECT module (80). Each one of said modules is a substrate, which has a calibration element and joining means to at least one connection module (5).

As regards the THRU module (60), said module is a substrate plate which has a THRU element (601), which are two series of metal pillars forming a pair of parallel lines that traverse the entire length of the module. As regards the joining means to other modules, this module has first holes (602) conjugated with corresponding holes in a connection module (5) and second holes (603) conjugated with corresponding holes in another connection module (5).

As regards the LINE module (70), said module is a substrate plate that has a LINE element (701), which are two series of metal pillars forming a pair of parallel lines that traverse the entire length of the module. As regards the joining means to other modules, this module has first holes (702) conjugated with corresponding holes in a connection module (5) and second holes (703) conjugated with corresponding holes in another connection module (5).

Unlike the THRU element (601), the LINE element (701) is of greater length than the THRU element, which allows that the signal suffers an additional gap, significant and necessary for the calibration.

Finally, the REFLECT module (80) is also a substrate plate that has a REFLECT element (801), which consists, in this embodiment, of two series of metallized holes that form a pair of parallel lines that only partially traverse the length of the module and which are connected, at their end which does not reach the end of the module, by a series of metal pillars perpendicular to both parallel lines. Since this calibration module only uses one output of the analyzer, the REFLECT module (80) has, unlike the aforementioned calibration modules, holes (802) conjugated with corresponding holes to a single connection module (5).

Figure 6 shows an exploded view of the calibration device of the present invention connected for the measurement of a THRU calibration signal by means of the connection of the THRU module (60) to two connection modules (5), one for each one of the connections to the analyzer.

In this figure, the connection cables (4) to the analyzer, which are connected to the calibration device, are observed, in particular, by means of the SMA connector (10). In addition to the parts of each one of the modules described above, this figure makes it possible to observe the manner of connection of the THRU module (60) to the connection modules (5) said connection is performed by disposing the modules adjacently, as the elements of the different modules come into contact it generates a connection between them. For this reason, it is important that the holes disposed in the strips (51, 52) and the conjugated holes (602, 603) of the THRU module (60) are configured so that this contact exists. Furthermore, it is particularly relevant that there are means of alignment (503) which guarantee that the modules are correctly aligned.

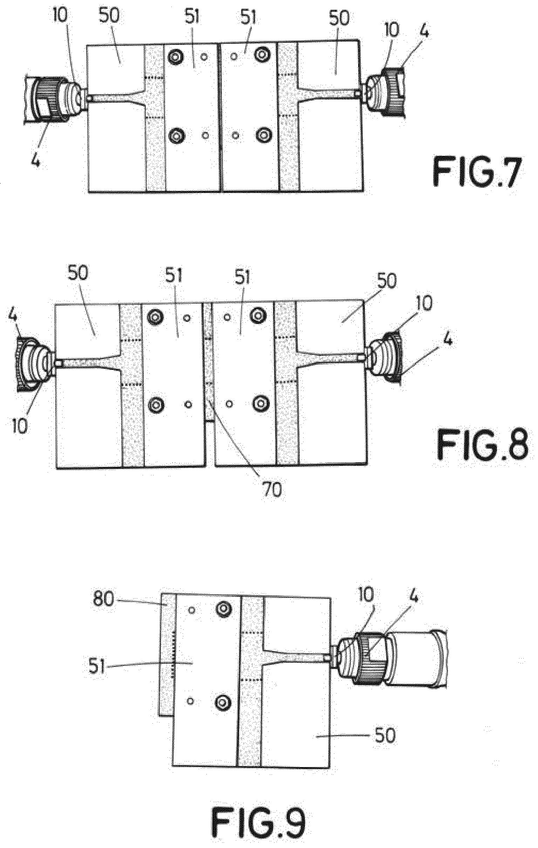

Figures 7, 8 and 9 show the calibration device of the present invention connected for the measurement of the different THRU, LINE and REFLECT calibration signals by means of the connection of the THRU module (60), the LINE module (70) and the REFLECT module (80) to the inputs or outputs of the analyzer as relevant.

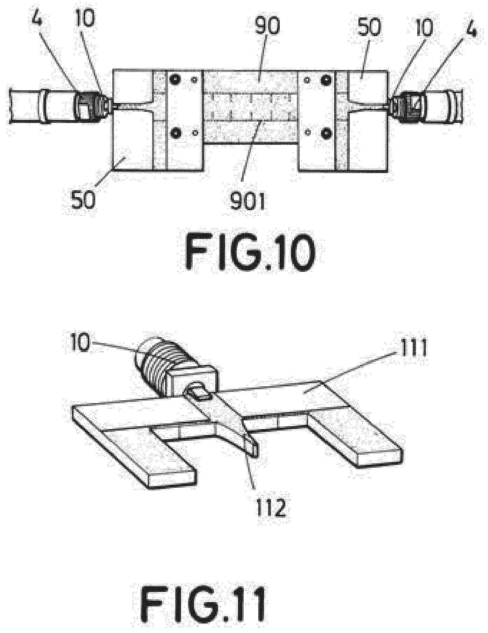

Figure 10 shows the calibration device of the present invention connected for the measurement of a DUT device. This DUT device corresponds to a module device (90) which, in the example of figure 10, has a band-pass filter (901). Similarly to the case of the calibration modules, this element has conjugated connection means to two connection modules (5) which will be connected to inputs or outputs of the analyzer by means of cables (4).

Figure 11 shows an example of transition means of a signal received by means of a SMA-to-ESIW connector (10). This figure is especially relevant since, like the signal of the SMA connector (10) it can be converted into a SIC signal by means of means known in the state of the art (previously explained making reference to figure 2), by means of known means, it may convert the signal from a SMA connector (10) to a ESIW signal.

In particular, if one works with ESIW devices instead of SIC devices, there is the advantage that, whilst in the SIC device, the signals pass throughout the modules traversing a dielectric, (contained in the substrate), in the case of ESIW the signals pass through the air, which significantly reduces the signal losses. In particular, figure 11 shows the implementation of ESIW in a substrate (111) which, furthermore, has a peak (112) for the transition of the signal to the air.

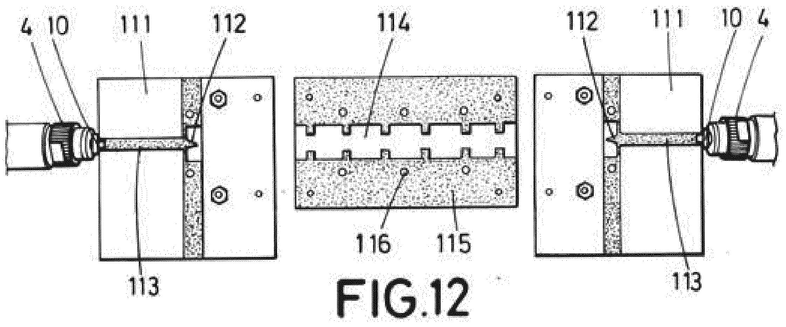

Figure 12 shows the calibration device of the present invention connected for the measurement of a DUT device (Device Under Test) with the calibration device being a device implemented in ESIW. In this case, the DUT used is a pass-band filter that generates a series of metal pillars (116) and a hole (114) in the substrate (111) through which the signal to measure will pass.

Therefore, the present invention contemplates transferring the concept of modularity explained for SIC technology, making reference to figures 1 to 10 to ESIW technology of figures 11 and 12. This is performed by creating a connection module with joining means to calibration modules and with calibration modules having joining means conjugated to that of the connection means.

## Claims

1. Network analyzer calibration device comprising:
• a first terminal designed to be connected to a network analyzer;
• a first calibration element disposed in a first calibration module; and
• a second calibration element disposed in a second calibration module;
**characterized in that** the first terminal is disposed in a first connection module (5) said first connection module having connection means to other modules and **in that** the first calibration module and the second calibration module comprise conjugated connection means to the connection means of the first connection module (5).

2. Network analyzer calibration device, according to claim 1, wherein said first and second calibration elements are substrate integrated elements.

3. Network analyzer calibration device, according to claim 1, wherein said first and second calibration elements are substrate integrated empty guides.

4. Network analyzer calibration device, according to claim 1, wherein said first and second calibration elements are microstrip lines.

5. Network analyzer calibration device, according to claim 2, wherein the first terminal is a SMA terminal (10) and wherein the first connection module comprises SMA-to-SIC transition means.

6. Network analyzer calibration device, according to claim 5, wherein the SMA-to-SIC transition means comprises SMA-to-microstrip transition means (501) and microstrip-to-SIC transition means (502).

7. Network analyzer calibration device, according to claim 3, wherein the first terminal is a SMA terminal (10) and wherein the first connection module comprises SMA-to-ESIW transition means.

8. Network analyzer calibration device, according to claim 7, wherein the SMA-to-ESIW transition means comprises SMA-to-microstrip transition means (501) and microstrip-to-ESIW transition means.

9. Network analyzer calibration device, according to claim 4, wherein the first terminal is a SMA terminal (10) and wherein the first connection module comprises SMA-to-microstrip transition means.

10. Network analyzer calibration device, according to any of claims 2, 3 or 4, wherein the first calibration element is a REFLECT element (801).

11. Network analyzer calibration device, according to any of claims 2, 3 or 4, comprising a second terminal designed to connect to the network analyzer.

12. Network analyzer calibration device, according to claim 11, wherein said second terminal is disposed in a second connection module (5) comprising connection means to other modules.

13. Network analyzer calibration device, according to claim 12, wherein the second calibration element comprises conjugated connection means both to the first and the second connection module.

14. Network analyzer calibration device, according to claim 12, wherein the second terminal is a SMA terminal (10) and wherein the second connection module comprises SMA-to-SIC transition means.

15. Network analyzer calibration device, according to claim 14, wherein the SMA-to-SIC transition means comprises SMA-to-microstrip transition means (501) and microstrip-to-SIC transition means (502).

16. Network analyzer calibration device, according to claim 12, wherein the second terminal is a SMA terminal and wherein the second connection module comprises SMA-to-ESIW transition means.

17. Network analyzer calibration device, according to claim 16, wherein the SMA-to-ESIW transition means comprises SMA-to-microstrip transition means and microstrip-to-ESIW transition means.

18. Network analyzer calibration device, according to claim 12, wherein the second terminal is a SMA terminal (10) and wherein the second connection module comprises SMA-to-microstrip transition means.

19. Network analyzer calibration device, according to claim 13, wherein the second calibration element is a THRU element (601).

20. Network analyzer calibration device, according to claim 13, wherein the second calibration element is a LINE element (701).

21. Networks calibration device, according to claim 13, comprising two second calibration modules one of said second calibration modules comprising a THRU element (601) and the other of said second calibration means comprising a LINE element (701).
